(19) Europäisches Patentamt / European Patent Office / Office européen des brevets

(11) **EP 2 359 476 B1**

(12) **EUROPÄISCHE PATENTSCHRIFT**

(45) Veröffentlichungstag und Bekanntmachung des Hinweises auf die Patenterteilung:
**20.05.2020  Patentblatt 2020/21**

(21) Anmeldenummer: **09799244.0**

(22) Anmeldetag: **18.11.2009**

(51) Int Cl.:
***H03K 17/955*** (2006.01)

(86) Internationale Anmeldenummer:
**PCT/EP2009/008213**

(87) Internationale Veröffentlichungsnummer:
**WO 2010/057625 (27.05.2010 Gazette 2010/21)**

(54) **KAPAZITIVES SENSORSYSTEM**

CAPACITIVE SENSOR SYSTEM

SYSTÈME DE CAPTEURS CAPACITIFS

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **18.11.2008  DE 102008057823**

(43) Veröffentlichungstag der Anmeldung:
**24.08.2011  Patentblatt 2011/34**

(73) Patentinhaber: **Microchip Technology Germany GmbH**
**82205 Gilching (DE)**

(72) Erfinder: **FASSHAUER, Peter**
**85579 Neubiberg (DE)**

(74) Vertreter: **sgb europe**
**Lechnerstraße 25a**
**82067 Ebenhausen (DE)**

(56) Entgegenhaltungen:
WO-A1-97/01835     WO-A1-98/07051
US-A- 4 939 382     US-A1- 2008 122 458

• ZACK ALBUS: "PCB-Based Capacitive Touch Sensing With MSP430" INTERNET CITATION 1. Oktober 2007 (2007-10-01), Seiten 1-25, XP002566917 [gefunden am 2007-10-01]

**Beschreibung**

Gebiet der Erfindung

Die Erfindung richtet sich auf ein kapazitives Sensorsystem insbesondere zur Erfassung von Objektannäherungen sowie insbesondere auch zur Gestenerkennung. Die Erfindung betrifft dabei ein Sensorsystem, bei welchem auf der Basis elektrischer Nahfelder die Annäherung bzw. Bewegung typischerweise einer Hand oder eines Fingers detektiert wird und hieraus Informationen abgeleitet werden, die zur Steuerung von Schaltvorgängen oder zum Erkennen einer räumlichen Geste herangezogen werden können.

Hintergrund der Erfindung

Insbesondere zur Gestenerkennung gibt es optische Verfahren im sichtbaren oder InfrarotBereich. Ferner sind kapazitiv wirkende Systeme bekannt, die über die Übertragung oder Störung eines elektrischen Feldes die erforderlichen Informationen gewinnen. Der schaltungstechnische Aufwand und die mit der Realisierung derartiger System verbundenen Kosten sind bislang hoch. Ein weiterer Problempunkt bei den herkömmlichen Systemen besteht darin, dass bei Anwendungen, die einen Batteriebetrieb erfordern, der Strombedarf solcher Sensoren entscheidend für die praktische Einsetzbarkeit ist. Weiterhin sind bei manchen Anwendungen die Bauteilkosten und der Raumbedarf von Bedeutung, die bzw. der bei Massen-Anwendungen, z.B. im Bereich der Spielzeugindustrie für die Einsatzmöglichkeit ausschlaggebend sein können.

Für eine kapazitives Sensorsystem ist die Auswertung der Kapazitätsänderung eines RC-Tiefpassgliedes bekannt. Als Anregungssignal wird hierbei eine sinusförmige Spannung oder auch ein Rechtecksignal verwendet. Als Signalindikator für die Änderung wird die Amplitude oder die Phase bzw. die Zeitverschiebung gegenüber einem Referenzsignal ausgewertet. Bei beiden Ansätzen (Amplitude oder Phase) kommt es auf die relative Änderung $\Delta C/C$ der Kapazitätsänderung gegenüber einer Grundkapazität C an, da hierdurch die Sensorempfindlichkeit bzw. die maximale Detektionsreichweite des Sensors bestimmt wird. Eine möglichst geringe Grundkapazität ist daher für eine maximale Empfindlichkeit anzustreben.

Eine kapazitive Sensoranordnung ist aus dem Dokument WO 98/07051 bekannt.

Aufgabe der vorliegenden Erfindung ist es, ein kapazitiv arbeitendes Sensorsystem bereitzustellen, das mit geringem Bauteileaufwand und damit geringen Kosten und Platzbedarf realisierbar ist und sich zudem auch durch einen niedrigen Stromverbrauch auszeichnet, um mit Batterien geringer Ladungskapazität bzw. hoher Betriebsdauer arbeiten zu können.

Diese Aufgabe wird erfindungsgemäß durch eine Schaltungsanordnung mit den in Patentanspruch 1 angegebenen Merkmalen gelöst.

Durch mehrere derartige Systeme ist es möglich eine 2- oder 3-dimensionale Positionserfassung zu bewerkstelligen. Es ist auch möglich, mehrere Sensorelektroden vorzusehen, und diese über eine Multiplexereinrichtung sukzessive an die Schaltung anzukoppeln. Diese Multiplexerschaltung kann durch den Mikrokontroller getriggert werden. Vorteilhafte Ausgestaltungen der erfindungsgemäßen Schaltungsanordnung sind Gegenstand der Unteransprüche.

Kurzbeschreibung der Figuren

Weitere Einzelheiten und Merkmale der Erfindung ergeben sich aus der nachfolgenden Beschreibung in Verbindung mit der Zeichnung. Es zeigt:

**Figur 1a**  eine Schaltungsskizze zur Veranschaulichung des Aufbaus einer erfindungsgemäßen Schaltungsanordnung;

**Figur 1b**  ein Ersatzschaltbild zur weiteren Veranschaulichung der im Rahmen einer Objektannäherung hinsichtlich ihrer Kapazität veränderten Kondensatoreinrichtungen,

**Figur 2**  ein Diagramm zur Veranschaulichung des Spannungsaufbaus;

**Figur 3**  ein weiteres Diagramm zur Veranschaulichung des Spannungsaufbaus;

**Figur 4**  eine Skizze zur Veranschaulichung des Einsatzes einer erfindungsgemäßen Schaltung bei einer Computermaus;

**Figur 5**  eine Skizze zur Veranschaulichung des Einsatzes eines mehrere Detektionselektroden umfassenden Gestenerfassungssystems;

**Figur** 6    zwei Skizzen zur Veranschaulichung der Realisierung erfindungsgemäßer Gestenerfassungssystem unter Verwendung relativ nahe nebeneinanderliegender Detektionselektroden.

Ausführliche Beschreibung der Figuren

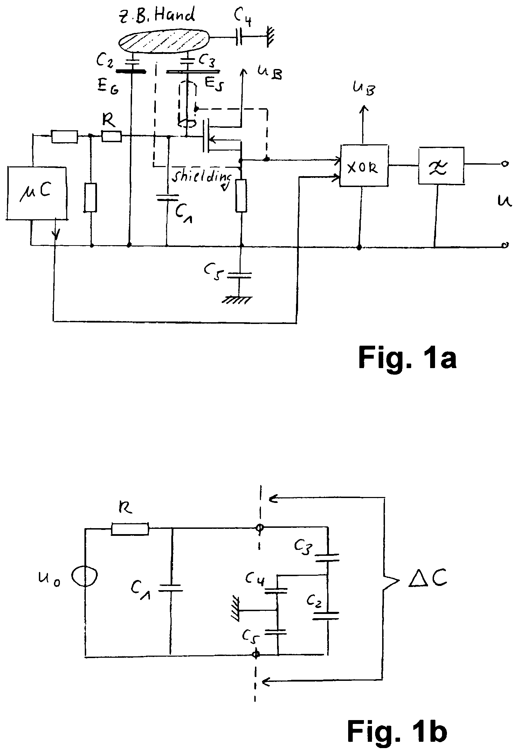

In Figur 1a ist eine erfindungsgemäße Schaltungsanordnung dargestellt. Diese umfasst einen kapazitiv arbeitenden, erfindungsgemäß aufgebauten Näherungssensor. Diese Schaltungsanordnung kann durch Mehrfachausführung zu einem Sensorsystem für eine Gestenerkennung erweitert werden.

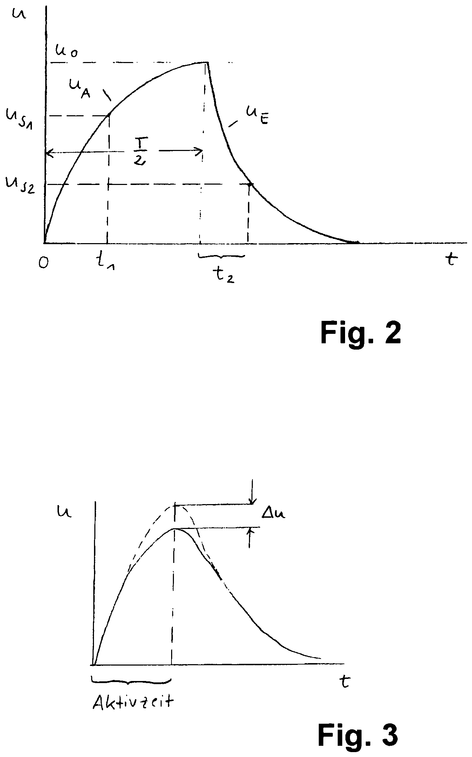

Zunächst wird die Funktionsweise dieser in Figur 1a dargestellten Anordnung näher erläutert. Mit einer von einem Mikrocontroller ($\mu$C) gelieferten Rechteckspannung im Frequenzbereich von vorzugsweise 80 bis 120 kHz kommt es nach einer Pegelanpassung des Signales durch einen Spannungsteiler auf eine Amplitude $u_0$ am Gate-Eingang eines Feldeffekttransistors (FET) aufgrund von mehreren dort wirkenden kapazitiven Einflüssen, gekennzeichnet durch C1 bis C5, zu einer exponentiellen Aufladung und Entladung wie in Figur 2 veranschaulicht.

Die parasitären Kapazitäten werden einmal gebildet durch die Feldkopplung zwischen einer mit $E_s$ bezeichneten Signalelektrode und einer Groundelektrode Eg der Schaltungsanordnung (C1) und zum anderen durch Kopplungskapazitäten C2 und C3 von einer sich an diese Elektroden nähernden Hand.

Die Kapazitäten C4 und C5 sind Kopplungskapazitäten der Hand bzw. des Schaltungsgrounds gegen Erde. Zunächst wird die Auf- und Entladung im Grundzustand ohne Annäherung (C2 = C3 = C4 = 0) betrachtet, wodurch nur C1 wirksam ist. Der Verlauf zum Erreichen eines bestimmten Schwellwertes $u_{S1}$ sei t1. Die Entladung erfolgt dann nach einer halben Periodendauer T des Rechtecksignales entsprechend $u_E$ und erreicht nach einer Zeit t2 wieder einen Schwellwert $u_{S2}$.

Daher gilt:

$$u_{S1} = u_0 (1-e^{-t1/RC1}) \qquad\qquad u_{S2}= u_0\, e^{-t2/RC1} \qquad\qquad (1)$$

Hieraus ergibt sich dann für die Schaltzeiten

$$t1= - RC1 \ln ( 1-u_{S1}/u_0) \qquad\qquad t2= - RC1 \ln (u_{S2}/u_0) \qquad\qquad (2)$$

Bei einer Kapazitätsänderung um $\Delta C$ auf C1+$\Delta C$ beträgt dann die Zeitverschiebung bei den Schwellwerten

$$\Delta t1= - R\Delta C \ln( 1-u_{S1}/u_0) \qquad und \quad \Delta t2 = -R\Delta C \ln (u_{S2}/u_0) \qquad\qquad (3)$$

Die gesamte Zeitverschiebung ist dann

$$\Delta t= \Delta t1+\Delta t2 = R\Delta C \left[ \ln (u_0/u_{S2}) - \ln ( 1-u_{S1}/u_0) \right] \qquad\qquad (4)$$

Gl.4 zeigt, dass $\Delta t$ umso größer wird, je näher die Schwelle $u_{S1}$ an $u_0$ liegt und je kleiner $u_{S2}$ im Verhältnis zu $u_0$ wird. Dies bedeutet, dass bei der Wahl der Schwellwerte eine geeignete Hysterese eines Schwellwertentscheiders günstig ist.

Im Falle $u_{S1}=u_{S2}$ ist es vorteilhaft, entweder die Schwelle möglichst nahe an $u_0$ oder 0 zu legen, da dann einer der beiden Terme in Gl.4 möglichst groß wird. Ferner ist die Zeitverschiebung und damit die Empfindlichkeit des Sensors umso höher, je größer der Ladewiderstand R und je größer die Kapazitätsänderung $\Delta C$ wird. Der Ladewiderstand darf dabei maximal so groß werden, dass es jeweils während einer Halbperiode T/2 des Rechtecksignales noch zu einer nahezu vollständigen Auf- und Entladung am Gate-Eingang eines Feldeffekttransistors kommt. Da R möglichst groß werden soll, hängt diese Forderung entscheidend von der zwischen Gate und Ground wirksamen Kapazität C1 ab (siehe Fig. 1a). Diese Grundkapazität der Schaltungsanordnung setzt sich aus mehreren parasitären Einzelkapazitäten zusammen. Ein Anteil wird gebildet von der Gate-Source Kapazität des FET, die in ihrer Wirkung auf den Eingang infolge einer Gegenkopplung durch den Source-Widerstand erheblich reduziert wird. In einer Versuchsschaltung erreicht man hierdurch Werte von ca. 0,2 pF.

Einen weiteren Beitrag zu C1 liefert die Kopplungskapazität zwischen der Signalelektrode $E_S$ und der mit Ground verbundenen Elektrode $E_G$. Um diese zu minimieren kann dazwischen eine sog. Shield-Elektrode eingefügt werden, die am Ausgang des Sourcefolgers angeschlossen wird und daher auf nahezu gleichem Potential wie das Gate liegt, wodurch die Kopplung $E_S$ und $E_G$ erheblich vermindert wird. Dies ist ein weiterer vorteilhafter Aspekt der FET-Stufe. Der Source Ausgang des FET kann auch dazu verwendet werden, bei weiter weg gelegenem Anschluss der Signalelektrode ES den Schirm eines Koaxialkabels zu treiben und dadurch die Kabelkapazität zu verringern, die ebenfalls einen Beitrag zu C1 liefern würde.

Die Ausführungen zeigen auf, dass die Verwendung eines FET's in Sourcefolger-Schaltung als Eingangsstufe erhebliche Vorteile mit sich bringt und zudem den Bauteileaufwand auf ein Minimum reduziert, wodurch sowohl Strombedarf als auch die Kosten sehr gering bleiben.

Zur Auswertung der bei Annäherung erfolgten Zeitverschiebung des Auf- und Entladevorganges wird ein XOR-Gatter verwendet, dessen Eingänge über integrierte Schmitt-Trigger geschaltet werden , wodurch kein zusätzlicher Comparator für die Schaltschwellen uS1 und uS2 notwendig ist und damit weitere Bauteile eingespart werden können. Die Zeitverschiebung wird repräsentiert durch eine Gleichspannung, die mittels eines am XOR-Ausgang angeschlossen Tiefpassfilters gewonnen wird. Bei einer Versorgungsspannung $u_B$ ist diese dann analog zu Gl.4

$$u = RC1u_B/T \left[ \ln \left( u_0/u_{S2} \right) - \ln \left( 1 - u_{S1}/u_0 \right) \right] \qquad (5)$$

Setzt man hierin 1/T = f , so erkennt man, dass die am Tiefpass-Ausgang gebildete Gleichspannung proportional zur Frequenz f des vom $\mu$C gelieferten Rechtecksignales ist. Da infolge unvermeidlicher Toleranzen, z.B. bei den Schwellwerten, diese Spannung in einem Produktionsprozess unterschiedlich sein kann, besteht eine Möglichkeit zum Toleranzausgleich darin , die Signalfrequenz über den $\mu$C so zu verändern, dass sich im Fall keiner Annäherung stets eine konstante Ausgangsspannung ergibt.

Entscheidend für die Empfindlichkeit einer Näherungserkennung ist die kapazitive Änderung $\Delta C$ am Gate-Eingang, die nach Gl. 4 zu einer entsprechenden Zeitverschiebung $\Box$t und damit am Tiefpassausgang zu einer proportionalen Spannungsänderung $\Delta u \sim \Delta C$ führt. Wie bereits oben ausgeführt wurde, hängt diese Änderung vor allem von den bei einer Annäherung wirksamen Koppelkapazitäten C2 bis C5 ab. Ein Ersatzbild (Fig.1b) der Anordnung von Fig.1a verdeutlicht diese Wirkungen. Eine größmögliche Änderung ergibt sich zunächst für den Fall, dass der Groundanschluss des Sensors direkt mit Erde verbunden ist, da dann die Parallelschaltung von C2 und C4 größtmöglich wird, wodurch auch $\Delta C$ den größtmöglichen Wert erreicht. Für den Fall, dass der Groundanschluss mit Erde keine oder nahezu keine Kopplung ausweist (C5 ~ 0), ist die Serienschaltung von C2 und C3 , d.h. den Koppelkapazitäten eines Körperteils, z.B. der Hand, zu den Elektroden $E_S$ und $E_G$, für die Änderung maßgeblich. Beim Schaltungsdesign kommt es also darauf an, C2 und C3 möglichst groß und C1 möglichst klein (z.B. durch shielding) zu gestalten.

Die Kopplung zur Groundelektrode $E_G$ muß nicht zwangsläufig durch eine separate Elektrode erfolgen, sondern kann je nach Anwendung auch durch eine andersartige Kopplung über z.B. die Batterien vorliegen. Durch die erfindungsgemäße Anordnung von Fig. 1a ergeben sich vielfältige Anwendungen und Gestaltungsmöglichkeiten insbesondere durch Elektrodenformen und Elektrodenkonfigurationen, wofür weiter unten Beispiele gegeben werden. Die mit Fig. 1a gegebene erfindungsgemäße Anordnung zeichnet sich nicht nur durch einen extrem geringen Aufwand an Bauteilen und damit Kosten und geringem Platzbedarf aus, sondern auch durch einen äußerst geringen Stromverbrauch im Sensor, der im wesentlichen durch den über den Sourcewiderstand des FET fließenden Strom gegeben ist. Bei Werten dieses Widerstandes im Bereich einiger kOhm lassen sich Ströme weit unter 1mA hiermit realisieren. Eine Besonderheit dieser Anordnung liegt auch darin, dass der Sensorbetrieb gepulst erfolgen kann, ohne dass hierbei besondere Einschwingprobleme auftreten. Bei Anwendungen mit Batteriebetrieb ist dies häufig eine zwingende Maßnahme, um die Batterieentladung im Bereich von nur einigen $\mu$A zu gewährleisten und damit eine entsprechend lange Betriebsdauer zu erreichen. Im Fall des Pulsbetriebes entsteht am Ausgang des Tiefpasses keine Gleichspannung mehr, sondern ein in Fig.3 dargestellter Auflade- und Entladeimpuls. Bei Annäherung steigt die Pulsamplitude um einen Wert $\Delta u$, der dem des Dauerbetriebes nach Gl. 5 entspricht. Durch Wahl eines entsprechend niedrigen Puls/Pause -Verhältnisses lassen sich Gesamtströme einschließlich des $\mu$C von wenigen $\mu$A erreichen.

Nachstehend werden zwei Beispiele für die Anwendung der Sensoranordnung gegeben.

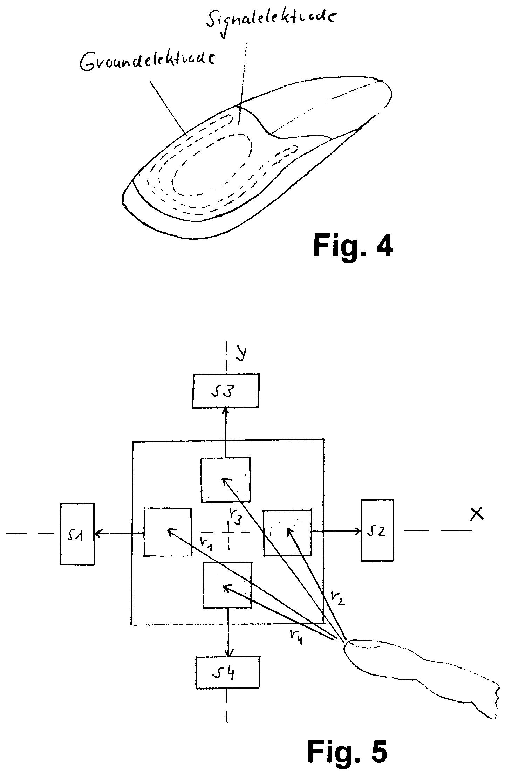

Im ersten Beispiel nach Figur 4 wird eine schnurlose Computermaus durch die erfindungsgemäße Sensorik bei Annäherung der Hand in den aktiven Zustand geschaltet, um den Batteriestrom auf einen geringst möglichen Wert zu begrenzen. Dazu wird die Signalelektrode an einem Teil der Innenseite der Oberschale des Gehäuses angebracht und kann noch mit einer streifenförmigen Groundelektrode umgeben werden. Die genaue Elektrodengestaltung hängt jeweils von der Form des Gehäuses ab, wobei je nach Gestaltung der Mauselektronik und der zugehörigen Batterieversorgung auf eine separate Groundelektronik möglicherweise auch verzichtet werden kann, wenn eine ausreichende Groundkopplung der Hand auch auf andere Weise, z.B. über die Batterien erfolgt. Durch Anwendung des Pulsbetriebes im Verhältnis von z.B. 1:1000 kann der Stromverbrauch aus der Batterie durch die Sensorik hiermit auf 1..2 $\mu$A reduziert werden.

Ein weiteres Beispiel für die Anwendung des Näherungssensors ist die Erkennung von Gesten mittels eines 4-Elektrodensystems, dessen Prinzip in Figur 5 im einzelnen veranschaulicht ist. Das Elektrodensystem einschließlich der zugehörigen Sensorelektronik soll dabei in möglichst kompakter Form auf kleinem Raum konzentriert bleiben, um es platzsparend in bereits vorhandene Einrichtungen vielfältiger Art integrieren zu können. Damit ergeben sich auch die oben bereits erläuterten weiteren Vorteile eines stromarmen Betriebes im Hinblick auf Batterieanwendungen sowie einer kostengünstigen Realisierung. Die Aufgabe besteht darin, aus den von den Sensoren gelieferten Informationen die x/y-Koordinaten einer Gesten-Bewegung bezüglich der von den Elektroden aufgespannten Ebene abzuleiten.

Dazu werden bei dem System nach Figur 5 die Abstände $r_1$ bis $r_4$ zu einem die Geste ausführenden Finger eingeführt. Hiermit ergeben sich in einem räumlichen x,y,z-Koordinatensystem mit dem Abstand a der Elektrodenschwerpunkte zum Ursprung die vier Gleichungen

$$r_1^2 = (x-a)^2 + y^2 + z^2 \qquad (6)$$

$$r_2^2 = (x+a)^2 + y^2 + z^2 \qquad (7)$$

$$r_3^2 = x^2 + (y+a)^2 + z^2 \qquad (8)$$

$$r_4^2 = x^2 + (y-a)^2 + z^2 \qquad (9)$$

Durch Differenzbildung von jeweils Gl .6 und 7 bzw. 8 und 9 erhält man sofort die x/y- Koordinaten zu

$$x = ( r_1^2 - r_2^2 ) / 4a$$

$$(10)$$

$$y = ( r_3^2 - r_4^2 ) / 4a$$

Wie die Gln. 6 bis 10 zeigen, können die x/y-Koordinaten unabhängig von z in einfacher Weise berechnet werden. Dazu müssen die Abstände $r_1$ bis $r_4$ aus den Signalen bestimmt werden, die am Ausgang der 4 Sensoren S1 bis S4 anliegen. Es werden nur die Signaldifferenzen betrachtet, die sich bei Annäherung gegenüber dem Grundzustand ergeben. Diese Differenzsignale seien mit $e_1$ bis $e_4$ bezeichnet und werden aus den oben beschriebenen Kapazitätsänderungen an den jeweiligen Gates der Feldeffekttransistoren abgeleitet. Maßgeblich hierfür ist jeweils die Koppelkapazität des Fingers zu den Elektroden, die mit zunehmendem Abstand von der Elektrode geringer wird. Da die gelieferte Amplitude der Signaldifferenz nach den Ausführungen von oben proportional zur Kapazitätsänderung ist , nehmen diese Werte mit größer werdendem Abstand ab. Hierfür wird näherungsweise ein Potenzgesetz angenommen entsprechend

$$e(r) = e_0 ( r_0 / r )^{\alpha} \qquad (11)$$

mit einem Exponenten $\alpha$, der in der Praxis je nach Elektrodenanordnung 2...3 beträgt.

Die Auflösung von Gl.11 nach r ergibt dann

$$r = r_0 ( e_0/e )^{1/\alpha} \qquad (12)$$

Mit den Gln. 10 lassen sich nun die Koordinaten aus den Signalen $e_1$ bis $e_4$ berechnen zu

$$x = [ (e_0/e_1)^{2/\alpha} - (e_0/e_2)^{2/\alpha} ] \, r_0^2 / 4a \qquad (13)$$

$$y = [ (e_0/e_3)^{2/\alpha} - (e_0/e_4)^{2/\alpha} ] \, r_0^2 / 4a \qquad (14)$$

Die Konstanten $e_0, r_0$ und a sind darin von der jeweiligen Elektrodenform und Anordnung der Elektroden zueinander abhängig.

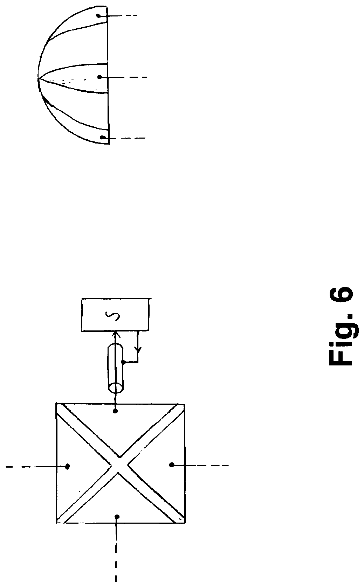

In Figur 6 sind verschiedene Elektrodenanordnungen dargestellt, die entweder direkt mit kurzen Verbindungen an die Elektronik angekoppelt werden und damit eine nur wenige $cm^2$ große kompakte Einheit bilden, die leicht in andere Systeme integrierbar ist oder mittels Koaxialkabel auch weiter von der Elektronik entfernt sein kann, wofür dann vorzugsweise der Kabelschirm mit dem Shielding-Ausgang des Sensors (Sourceanschluss des FET) verbunden wird, um die Grundkapazität C1 am Gateanschluss niedrig zu halten.

Vorteile der Anordnung

Zusammenfassend werden mit der erfindungsgemäßen Anordnung eines kapazitiven Näherungssensors folgende Vorteile nochmals herausgestellt:

1. Der Aufwand an Bauteilen ist mit einer einzigen FET-Eingangsstufe, einem XOR-Gatter und wenigen Widerständen und einem Kondensator extrem gering. Der für die Signalgenerierung und Verarbeitung erforderliche Mikrokontroller ist bei der Integration des Sensors in andere Systeme häufig bereits vorhanden und kann für die einfachen erforderlichen Sensorfunktionen mitbenutzt werden.

2. Der als Sourcefolger geschaltete FET liefert infolge der Gegenkopplung nicht nur eine sehr geringe Eigenkapazität des Sensors , sondern kann zudem als Ausgang für einen Shieldingbetrieb dienen , um die für die Empfindlichkeit maßgebliche Grundkapazität des Sensors zu verringern. Darüber hinaus bietet diese Maßnahme eine hohe Temperaturstabilität der Sensorfunktion und reduziert die Exemplarstreuung.

3. Eine Folge der geringen Zahl an aktiven Bauteilen ist ein sehr niedriger Stromverbrauch, der wegen sehr kurzer Einschwingvorgänge der Anordnung mittels eines gepulsten Betriebes auf wenige μA reduziert werden kann, wodurch sich erhebliche Vorteile bei einem Batteriebetrieb ergeben.

4. Durch geeignete Wahl der Elektrodenanordnung kann die Näherungsfunktion von einer notwendigen Kopplung gegen Erde gelöst werden. Dies ist fürAnwendungen mit Batteriebetrieb wesentlich.

5. Eine infolge von Toleranzen erforderliche Selbstkalibierung des Sensors kann in einfacher Weise durch eine Frequenznachstimmung erfolgen.

6. Durch Verändern des Ladewiderstandes am Gateeingang kann eine sehr flexible Anpassung an unterschiedliche Elektrodenkapazitäten infolge unterschiedlicher Elektrodengrößen erfolgen. Ferner kann hiermit auch eine optimale Frequenzanpassung bezüglich Fremdstörer vorgenommen werden.

7. Die Reaktionszeit des Sensors kann durch flexible Wahl einer möglichst hohen Signalfrequenz bis auf wenige Millisekunden reduziert werden.

8. Bei Mehrelektroden-Anordnungen wie z.B. bei einer Sensorik zur Gestenerkennung kann der gesamte Sensor platzsparend auf nur wenigen cm2 untergebracht werden.

Eine besondere Maßnahme bei der erfindungsgemäßen Schaltung liegt in der besonders einfachen und damit strom-und kostensparenden Realisierung des Näherungssensors mit einer einzigen FET-Stufe und einem nachgeschaltetem EXOR-Gatter ohne dass ein zusätzlicher Comparator erforderlich ist. Zum anderen liefert die FET-Stufe soweit diese als Sourcefolger geschaltet ist eine äußerst geringe Eingangskapazität und erlaubt damit einen hohen, für die Empfindlichkeit maßgeblichen Vorwiderstand, der gegenüber herkömmlichen Sensoren um bis zu einem Faktor 50 höher liegt. Weiterhin bietet die Stufe in dieser Konfiguration gleichzeitig auch eine Shieldingfunktion, mittels der bei kritischen Einbausituationen die Eingangsgrundkapazität niedrig gehalten werden kann und damit kein relevanter Empfindlichkeitsverlust eintritt.

Der Vergleich mit herkömmlichen Sensoren zeigt, dass die Realisierung des erfindungsgemäßen Näherungssensors nach dem RC-Verfahren auch mit einer geringerer Zahl an Komponenten sogar zu einer höheren Leistungsfähigkeit führt.

Das erfindungsgemäße Konzept zeichnet sich durch einen besonders niedrigen Stromverbrauch aus und eignet sich insbesondere für Batterieanwendungen. Die hauptsächlich durch die Zahl der aktiven Bauelemente einer Schaltungsanordnung bestimmen Kosten und der Platzbedarf sind deutlich geringer als bei herkömmlichen Konzepten. Das erfindungsgemäße Schaltungskonzept eignet sich in besonders vorteilhafter Weise für System mit einem gleichzeitigem Betrieb mehrerer Sensoren wie z.B. für eine Gestik-Anwendungen.

**Patentansprüche**

1. Schaltungsanordnung zur Generierung eines mit einem Näherungsvorgang korrelierenden Ausgangssignales aufgrund von Änderungen der dielektrischen Eigenschaften der Umgebung einer Sensorelektrode ($E_S$), mit:

   - einer Sensorelektrode ($E_S$) die zumindest abschnittsweise an einen Observationsbereich angrenzt;
   - einer Mikrocontrollerschaltung ($\mu$C) zur Ausgabe einer alterierenden Rechteckspannung;
   - einer Spannungsteilerschaltung zur Bewerkstelligung einer Pegelanpassung der seitens des Mikrokontrollers ($\mu$C) ausgegebenen alternierenden Rechteckspannung,
   - und einem Feldeffekttransistor (FET) in der Funktion eines Impedanzwandlers, wobei der Feldeffekttransistor derart in die Schaltungsanordnung eingebunden ist, dass die seitens der Spannungsteilerschaltung ausgegebene Spannung an dessen Gate und gleichzeitig an der Sensorelektrode (Es) anliegt, und der Feldeffekttransistor in Sourcefolger Schaltung als Eingangsstufe in die Schaltungsanordnung eingebunden ist, wobei ein Sourceanschluss des FET mit dem Eingang einer Auswerteschaltung (XOR) verbunden ist, und
   - einer Kondensatoreinrichtung ($C_1$) welche zwischen Gate und einem Bezugspotential geschaltet ist und einem dem Gate-Eingang vorgeschalteten Ladewiderstand (R),
   - wobei eine Aufladung der Kondensatoreinrichtung ($C_1$) über eine erste halbe Periodendauer (T/2) erfolgt und die Entladung der Kondensatoreinrichtung ($C_1$) über eine nachfolgende zweite halbe Periodendauer (T/2) der Rechteckspannung erfolgt.

2. Schaltungsanordnung nach Anspruch 1, **dadurch gekennzeichnet, dass** die Wirkung von parasitären Kapazitäten, die aus der Gatekapazität des FET, der Sensorelektrodenkapazität gegen das Bezugspotential und aufbaubedingten Schaltungskapazitäten gebildet werden, als Kondensatoreinrichtung ($C_1$) für die Sensorfunktion genutzt wird.

3. Schaltungsanordnung nach Anspruch 2, **dadurch gekennzeichnet, dass** die von dem Mikrocontroller gelieferte Rechteckspannung im Frequenzbereich von 80 bis 120 kHz liegt.

4. Schaltungsanordnung nach wenigstens einem der Ansprüche 1 bis 3, **dadurch gekennzeichnet, dass** die Schaltzeiten $t_1$ und $t_2$ durch erste und zweite Schwellwertspannungen $u_{s1}$, $u_{S2}$ bestimmt werden, wobei gilt:

$$t_1 = -RC_1 \ln(1 - u_{s1}/u_0) \qquad t_2 = -RC_1 \ln(u_{S2}/u_0),$$

wobei R den Ladewiderstand und $C_1$ die Kapazität der Kondensatoreinrichtung ($C_1$) repräsentiert und $u_0$ die maximale Ladespannung der Kondensatoreinrichtung ($C_1$) ist.

5. Schaltungsanordnung nach wenigstens einem der Ansprüche 1 bis 4, **dadurch gekennzeichnet, dass** der Näherungsvorgang auf Grundlage einer Zeitverschiebung erfasst wird.

6. Schaltungsanordnung nach wenigstens einem der Ansprüche 1 bis 5, **dadurch gekennzeichnet, dass** der Ladewiderstand derart festgelegt ist, dass dieser maximal so groß ist, dass es jeweils während einer Halbperiode T/2 der Rechteckspannung noch zu einer nahezu vollständigen Auf- und Entladung am Gate-Eingang des Feldeffekttransistors kommt.

7. Schaltungsanordnung nach Anspruch 6, **dadurch gekennzeichnet, dass** eine mit dem Bezugspotential verbundene Koppelungselektrode ($E_G$) vorgesehen ist.

8. Schaltungsanordnung nach Anspruch 7, **dadurch gekennzeichnet, dass** eine Koppelungskapazität zwischen der Sensorelektrode (Es) und der Koppelungselektrode ($E_G$) einen weiteren Beitrag zur Kapazität der Kondensatoreinrichtung ($C_1$) liefert.

9. Schaltungsanordnung nach Anspruch 8, **dadurch gekennzeichnet, dass** zwischen der Sensorelektrode (Es) und der mit dem Bezugspotential verbundenen Koppelungselektrode ($E_G$) eine Shield-Elektrode vorgesehen ist.

10. Schaltungsanordnung nach Anspruch 9, **dadurch gekennzeichnet, dass** diese Shieldelektrode mit dem Sourceanschluss des FET verbunden ist und auf nahezu gleichem Potential wie das Gate liegt, wodurch eine Kopplung zwischen der Sensorelektrosde ($E_s$) und der Kopplungselektrode ($E_G$) vermindert wird.

11. Schaltungsanordnung nach wenigstens einem der Ansprüche 1 bis 10, **dadurch gekennzeichnet, dass** der Sourceanschluss des FET dazu verwendet wird, bei weiter weg gelegenem Anschluss der Signalelektrode ($E_S$) einen Schirm eines Koaxialkabels zu treiben und dadurch eine Kabelkapazität zu verringern.

12. Schaltungsanordnung nach wenigstens einem der Ansprüche 1 bis 11, **dadurch gekennzeichnet, dass** die Auswerteschaltung zur Auswertung der bei Annäherung erfolgten Zeitverschiebung des Auf- und Entladevorganges ein Exklusiv-Oder-Gatter (XOR) aufweist, dessen Eingänge über integrierte Schmitt-Trigger geschaltet werden.

13. Schaltungsanordnung nach Anspruch 12, **dadurch gekennzeichnet, dass** die Zeitverschiebung durch eine Gleichspannung repräsentiert wird, die mittels eines am XOR - Ausgang angeschlossen Tiefpassfilters gewonnen wird.

14. Verfahren zur Detektion eines Näherungsvorgang mit einer Schaltungsanordnung nach wenigstens einem der Ansprüche 1 bis 13, mit den Schritten:

   - Erzeugen der alternierenden Rechteckspannung mittels der Mikrocontrollerschaltung ($\mu$C); Ermittlung von Schwellwertzeiten ($t_1$, $t_2$) während der Aufladung und Entladung der Kondensatoreinrichtung ($C_1$);
   - Detektion eines Näherungsvorgang anhand der ermittelten Schwellwertzeiten ($t_1$, $t_2$).

**Claims**

1. A circuit arrangement for generating an output signal correlating with an approximation process on the basis of changes in the dielectric properties of the surroundings of a sensor electrode (Es), comprising:

   - a sensor electrode (Es) which at least in sections is adjacent to an observation area;
   - a microcontroller circuit ($\mu$C) for output of an alternating square wave voltage;
   - a voltage divider circuit for adjusting the level of the alternating square-wave voltage output by the microcon-troller ($\mu$C),
   - and a field effect transistor (FET) in the function of an impedance converter, the field effect transistor being integrated into the circuit arrangement in such a way that the voltage output by the voltage divider circuit is present at its gate and at the same time on the sensor electrode (Es), and the field effect transistor in source follower set-up is integrated as an input stage in the circuit arrangement, a source connection of the FET being connected to the input of an evaluation circuit (XOR), and
   - a capacitor device ($C_1$) which is coupled between the gate and a reference potential and a charging resistor (R) connected upstream of the gate input,
   - wherein the capacitor device ($C_1$) is charged over a first half period (T / 2) and the capacitor device ($C_1$) is discharged over a subsequent second half period (T / 2) of the square-wave voltage.

2. The circuit arrangement according to claim 1, **characterized in that** the effect of parasitic capacitances, which are formed by the gate capacitance of the FET, the sensor electrode capacitance against the reference potential and structure-related circuit capacitances, is used as a capacitor device ($C_1$) for the sensor function.

3. The circuit arrangement according to claim 2, **characterized in that** the square-wave voltage supplied by the microcontroller is in the frequency range from 80 to 120 kHz.

4. The circuit arrangement according to at least one of claims 1 to 3, **characterized in that** the switching times $t_1$ and $t_2$ are determined by first and second threshold voltages $u_{s1}$, us2, where:

$$t_1 = - RC_1 \ln (1-u_{s1} / u_0) \qquad t_2 = - RC_1 \ln (u_{S2} / u_0),$$

where R represents the charging resistance and $C_1$ represents the capacitance of the capacitor device ($C_1$) and $u_0$ is the maximum charging voltage of the capacitor device ($C_1$).

5. The circuit arrangement according to at least one of claims 1 to 4, **characterized in that** the approximation process is realized on the basis of a time shift.

6. The circuit arrangement according to at least one of claims 1 to 5, **characterized in that** the charging resistance is fixed in such a way, that at a maximum it has a value, that still almost a complete charging and discharging is achieved during a half period T / 2 of the square-wave voltage at the gate input of the field effect transistor.

7. The circuit arrangement according to claim 6, **characterized in that** a coupling electrode (EG) connected to the reference potential is provided.

8. The circuit arrangement according to claim 7, **characterized in that** a coupling capacitance between the sensor electrode (Es) and the coupling electrode (EG) provides a further contribution to the capacitance of the capacitor device ($C_1$).

9. The circuit arrangement according to claim 8, **characterized in that** a shielding electrode is provided between the sensor electrode (Es) and the coupling electrode (EG) connected to the reference potential.

10. The circuit arrangement according to claim 9, **characterized in that** this shielding electrode is connected to the source terminal of the FET and is at almost the same potential as the gate, whereby a coupling between the sensor electrode (Es) and the coupling electrode (EG) is reduced.

11. The circuit arrangement according to at least one of claims 1 to 10, **characterized in that** the source terminal of the FET is used to drive a shield of a coaxial cable when the connection of the signal electrode (Es) is further away and thereby to reduce a cable capacity.

12. The circuit arrangement according to at least one of claims 1 to 11, **characterized in that** the evaluation circuit for evaluating the approximate time shift of the charging and discharging process upon approximation has an exclusive-OR gate (XOR), the inputs of which are switched via integrated Schmitt triggers.

13. The circuit arrangement according to claim 12, **characterized in that** the time shift is represented by a DC voltage which is obtained by means of a low-pass filter connected to the XOR output.

14. A method for detecting an approximation process with a circuit arrangement according to at least one of claims 1 to 13, comprising the steps:

   - generating the alternating square-wave voltage by means of the microcontroller circuit ($\mu$C);
   - determination of threshold times ($t_1$, $t_2$) during the charging and discharging of the capacitor device ($C_1$);
   - detection of an approximation process based on the determined threshold times ($t_1$, $t_2$).

**Revendications**

1. Configuration de circuit pour la génération d'un signal de sortie corrélé avec un processus d'approche sur la base de modifications des propriétés diélectriques de l'environnement d'une électrode de capteur (Es), avec :

   - une électrode de capteur (Es) qui est adjacente, au moins à certains endroits, à une zone d'observation ;
   - un circuit de micro-contrôleur ($\mu$C) pour la sortie d'une tension rectangulaire alternative ;
   - un circuit diviseur de tension pour la réalisation d'une adaptation du niveau de la tension rectangulaire alternative générée du côté du micro-contrôleur ($\mu$C)
   - et un transistor à effet de champ (FET) qui remplit la fonction d'un convertisseur d'impédance, le transistor à effet de champ étant intégré dans la configuration de circuit de façon à ce que la tension générée du côté du micro-contrôleur soit appliquée à sa grille et simultanément à l'électrode de capteur (Es) et le transistor à effet de champ est intégré dans un circuit à source suiveuse en tant qu'étage d'entrée dans la configuration de circuit, une borne de source du FET étant reliée avec l'entrée d'un circuit d'analyse (XOR) et
   - un dispositif à condensateur ($C_1$) qui est branché entre la grille et un potentiel de référence et une résistance de charge (R) branchée en amont à l'entrée de la grille,
   - une charge du dispositif à condensateur ($C_1$) ayant lieu sur une première demi-période (T/2) et la décharge du dispositif à condensateur ($C_1$) ayant lieu sur une deuxième période suivante (T/2) de la tension rectangulaire.

2. Configuration de circuit selon la revendication 1, **caractérisée en ce que** l'action de capacités parasitaires, provenant de la capacité de la grille du FET, de la capacité de l'électrode de capteur par rapport au potentiel de référence et des capacités du circuit dues à sa structure, est utilisée en tant que dispositif à condensateur ($C_1$) pour le fonctionnement du capteur.

3. Configuration de circuit selon la revendication 2, **caractérisée en ce que** la tension rectangulaire délivrée par le micro-contrôleur se trouve dans la plage de fréquence de 80 à 120 kHz.

4. Configuration de circuit selon au moins l'une des revendications 1 à 3, **caractérisée en ce que** les temps de commutation $t_1$ et $t_2$ sont déterminés par des première et deuxième tensions à valeurs seuils $u_{s1}$, $u_{s2}$, moyennant quoi :

$$t_1 = -RC_1 \ln \left(1 - u_{s1} / u_{s0}\right) \qquad t_2 = -RC_1 \ln \left(u_{s2}/u_{s0}\right),$$

R étant la résistance de charge et $C_1$ la capacité du dispositif à condensateur ($C_1$) et $u_0$ étant la tension de charge maximale du dispositif à condensateur ($C_1$).

5. Configuration de circuit selon au moins l'une des revendications 1 à 4, **caractérisée en ce que** le processus d'approche est détecté sur la base d'un décalage temporel.

6. Configuration de circuit selon au moins l'une des revendications 1 à 5, **caractérisée en ce que** la résistance de charge est déterminée de façon à être assez importante pour que, pendant une demi-période (T/2) de la tension rectangulaire, une charge et une décharge presque entière a encore lieu à l'entrée de la grille du transistor à effet de champ.

7. Configuration de circuit selon la revendication 6, **caractérisée en ce qu'**une électrode de couplage (EG) reliée au potentiel de référence est prévue.

8. Configuration de circuit selon la revendication 7, **caractérisée en ce qu'**une capacité de couplage entre l'électrode de capteur (Es) et l'électrode de couplage (EG) apporte une contribution supplémentaire à la capacité du dispositif à condensateur ($C_1$).

9. Configuration de circuit selon la revendication 8, **caractérisée en ce que**, entre l'électrode de capteur (Es) et l'électrode de couplage (EG) reliée avec le potentiel de référence, est prévue une électrode de blindage.

10. Configuration de circuit selon la revendication 9, **caractérisée en ce que** cette électrode de blindage est reliée avec la borne de source du FET et se trouve presque au même potentiel que la grille, ce qui diminue un couplage entre l'électrode de capteur (Es) et l'électrode de couplage (EG).

11. Configuration de circuit selon au moins l'une des revendications 1 à 10, **caractérisée en ce que** la borne de source du FET est utilisée pour exciter, lorsque la borne de l'électrode de signal (Es) est disposée plus loin, un blindage d'un câble coaxial et pour réduire ainsi une capacité du câble.

12. Configuration de circuit selon au moins l'une des revendications 1 à 11, **caractérisée en ce que** le circuit d'analyse comprend, pour l'analyse du décalage temporel du processus de charge et décharge apparaissant lors de l'approche, une porte logique OU EXCLUSIF (XOR) dont les entrées sont commutées par l'intermédiaire de bascules de Schmitt intégrées.

13. Configuration de circuit selon la revendication 12, **caractérisée en ce que** le décalage temporel est représenté par une tension continue qui est obtenue au moyen d'un filtre passe-base connecté à la sortie XOR.

14. Procédé pour la détection d'un processus d'approche avec une configuration de circuit selon au moins l'une des revendications 1 à 13, avec les étapes suivantes :

   - génération d'une tension rectangulaire alternative au moyen du circuit à micro-contrôleur ($\mu$C) ;
   - détermination de temps de valeurs seuils ($t_1$, $t_2$) pendant la charge et la décharge du dispositif à condensateur

$(C_1)$ ;
- détection d'un processus d'approche à l'aide des temps de valeurs seuils $(t_1, t_2)$ déterminés.

**Fig. 1a**

**Fig. 1b**

Fig. 2

Fig. 3

**Fig. 4**

**Fig. 5**

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9807051 A